# EUROPEAN PATENT APPLICATION

(11) **EP 4 598 313 A1**
(43) Date of publication of application: **06.08.2025**
(21) Application number: 24155385.8
(22) Date of filing: 01.02.2024
(51) Int. Cl.: H10K 30/40, H10K 71/40, H10K 85/50

(54) **PEROVSKITE FILM ON A SUBSTRATE**

(71) Applicant: Perovskavolt GmbH, 6300 Zug (CH)
(72) Inventor: KHAKPOUR, Zhila, Karaj 3154996456 (IR); HEIDARIRAMSHEH, Maryam, Tehran 11748857783 (IR); TAGHAVINIA, Nima, Tehran 1396833473 (IR)
(74) Representative: Keller Schneider Patent- und Markenanwälte AG

(57) **Abstract**

In a process for the formation of a perovskite film on a substrate, in particular for the manufacture of a perovskite solar cell, wherein a solution comprising perovskite-precursors and a solvent is deposited on the substrate with which a wet perovskite film is formed on the substrate, the wet perovskite film is processed by a flow of a carrier gas and a processing agent, wherewith the wet perovskite film is processed by the processing agent. A device for the formation of a perovskite film on a substrate, comprising a coating set up for coating a substrate with a solution comprising perovskite-precursors and a solvent, wherewith a wet perovskite film can be deposited on the substrate, and a carrier gas supply device with which a gas flow can be directed to coating set up. The carrier gas supply device further comprises at least one injection port for injecting a processing agent into the carrier gas, wherewith the wet perovskite film can be processed by the processing agent.

## Description

### Technical Field

The invention relates to a process for the formation of a perovskite film on a substrate, in particular for the manufacture of a perovskite solar cell, wherein a solution comprising perovskite-precursors and a solvent is deposited on the substrate with which a wet perovskite film is formed on the substrate. The invention further relates to a device for the formation of a perovskite film on a substrate and to the use of the device for manufacturing of perovskite solar cells.

### Background Art

A perovskite solar cell is a device consisting of multiple layers stacked on a substrate. The perovskite film is the main layer in the device, which absorbs light and generates photo-carriers. The quality of the perovskite film is of critical importance, in terms of efficiency, long term stability, and reproducibility of the device in the production process.

Therefore the deposition of the perovskite film is a major step in the production of perovskite solar cells.

Perovskite film deposition generally consists of three consecutive processes:
1. Wet film formation;
2. Intermediate phase formation;
3. Nucleation/growth of perovskite phase.

Proper processing of the wet film is crucial for final high quality films.

The wet film undergoes two distinct regimes: low viscosity regime, followed by high viscosity regime. The low viscosity regime is the first stage of wet film formation, where the solvent is predominantly existing and the viscosity of the fluid is low. After a certain time, usually of a few seconds, the solvent is partly evaporated and the film goes into the high viscosity regime. This invention relates more preferably to a treatment on the wet film at high viscosity regime.

For small sample preparations using spin coating, a process called anti-solvent dripping is used to remove the extra solvent from the wet film. However, this is not a scalable process and is usually performed in an inert gas glovebox.

On the other hand, air knife processing is used for larger substrates coated by slot die or blade coating. Air knife is a high speed flow of air on the wet film and helps remove the residual solvents from the film. The concept of air knife has been also utilized in spin coating by flowing air (or N₂) over the wet film during the spin coating.

All the mentioned processes on the wet film lack sufficient control parameters for ideal wet film processes.

The disadvantage of the known methods is that the processing of perovskite film in the production of perovskite solar cells is generally slow. Further, the methods known in the art are not sufficiently scalable and controllable. This leads to the production of solar cells, which have a relatively low efficiency in converting solar energy into electricity.

### Summary of the invention

It is the object of the invention to create a process pertaining to the technical field initially mentioned, that leads to more efficient perovskite solar cells.

In particular, the invention aims for a scalable, controllable and rapid processing of perovskite film in the production of perovskite solar cells. This invention is preferably related to a modification process on wet film, and more preferably to a treatment on the wet film at high viscosity regime.

The solution of the invention is specified by the features of claim 1. According to the invention, the wet perovskite film is processed by a flow of a carrier gas and a processing agent, wherewith the wet perovskite film is processed by the processing agent.

The role of reactive gas is additive engineering on the viscous wet film. The reactive gas is partly dissolved into the wet film, doping the film in a very controlled way. Selection of proper reactive gasses for this additive engineering process results in various beneficial properties. In particular by processing the wet perovskite film with a processing agent, the film is preferably modified in such a way that the properties of the solar cell can be improved, in particular stabilizing the intermediate phase, improving the final perovskite film morphology, enhancing the reproducibility of the results, the performance of the final perovskite solar cell, service life, etc. The particular advantage of this process is that the processing agent does not have to be added to the perovskite-precursors and a solvent before forming the film on the substrate, but can be added separately. This means that agents that are difficult to retain in the precursor solution can also be introduced into the coating in a homogeneous manner.

The technique according to the invention makes it possible to introduce almost any material into the perovskite layer without negatively affecting the quality of the coating (homogeneity and uniformity) and at the same time increasing the quality of the solar cell.

Another objective of the present invention is in particular to add new chemical functionalities into the perovskite film, by injecting trace reactive materials into the air flow, in order to dope the perovskite film. This is essential in order to obtain high quality layers of perovskite.

Another objective of the present invention is in particular to provide a wide processing window for reproducible converting the intermediate thin film to the final perovskite film. Based on the Lewis acid-base adduct approach, using an alternative Lewis base with a high boiling point instead of DMSO, the processing window could be extended. However, the complete removal of the excess solvent is challenging. To solve this issue and broaden the process window, the reactive gas flow with suitable temperature is preferably adjusted to optimize the AX and PbX₂ interactions.

Another objective of the present invention, is in particular to passivate various defects at the interface, surfaces and grain boundaries by injecting additive materials into the air flow.

A device for the formation of a perovskite film on a substrate, comprises a coating set up for coating a substrate with a solution comprising perovskite-precursors and a solvent, wherewith a wet perovskite film can be deposited on the substrate. The device further comprises a carrier gas supply device with which a gas flow can be directed to coating set up, in particular to the substrate comprising the wet perovskite film. The carrier gas supply device further comprises at least one injection port for injecting a processing agent into the carrier gas, wherewith the wet perovskite film can be processed by the processing agent.

The device can comprise one or more injection port for injecting a processing agent into the carrier gas. Therewith, in every injection port different processing agents can be applied, preferably in pure form. However, an injection port can also be used for injecting a mixture of several processing agents.

The device is used for the production of perovskite solar cells, in particular for the step of building the perovskite layer on the substrate.

The perovskite-precursors are solved or suspended in a solvent, preferably in a pure, a binary or a ternary or in other mixtures of solvents. The solvent can comprise one or more of the following: 2-methoxy ethanol (2-ME), ionic liquids (IL) such as methyl ammonium acetate (MAAc), Tetrahydrofuran (THF), acetone complexes, Gamma butyrolactone (GBL), N-methyl-2-pyrrolidone (NMP). In a preferred embodiment, the solvent is a mixture of DMF (dimethylformamide) and DMSO (dimethylsulfoxide) in a ratio per volume between 3:1 and 4:1, preferably between 3.5:1 and 3.6:1.

The substrate can be any known by the skilled in the art, in particular glass/SnO₂, in particular glass having a layer of SnO₂ or the like. The substrate can in particular be a glass/TCF, where TCF is a transparent conductive film, usually SnO₂:F (FTO) and indium tin oxide (ITO).

Preferably, the processing by the carrier gas and the processing by the processing agent overlap in time. In variants, the processing by the carrier gas and the processing by the processing agent can be carried out alternately, in particular sequentially.

Preferably, a flow of a reactive gas at controlled temperature over the wet film is used, when the wet film is preferably in high-viscosity regime. By this process the solvent evaporation can be controlled (by flow and temperature control), and a gas phase additive engineering on the wet film can be made (by adding a reactive gas into the carrier gas, in particular flowing air, argon, N₂ etc.).

Preferably, the process comprises at least one of the following features:
i) during the processing with the processing agent, the wet perovskite film is in a high viscosity regime;
ii) a flow speed of the flow of the carrier gas is controlled in order to regulate the solvent evaporation from the wet perovskite film, wherein, in particular, the flow of the carrier gas starts, when the wet perovskite film is in high viscosity regime, in particular between 0.1 second and 10 seconds after the wet perovskite film is formed on the substrate;
iii) a temperature of the carrier gas is controlled;
iv) the processing agent, in particular a reactive agent, preferably with a certain dose, is injected into the carrier gas in order to deposit the reactive agent into the wet film.

Preferably, the process comprises all of the above features.

Preferably, the processing agent is adsorbed at least partially in the wet perovskite film. Depending of the processing agent, the processing agent can be solved in the wet perovskite film. Further it is possible that the processing agent is suspended in the wet perovskite film. In Variants, the processing agent can be deposited, in particular only, on the surface of the wet perovskite film.

Preferably, between forming the wet perovskite film and processing the wet perovskite film by the gas flow, a viscosity of the wet perovskite film is increased, in particular by evaporating the solvent at least partially, in particular by heating, by vaporizing under negative pressure or a combination thereof. It is not absolutely necessary that vaporisation/evaporation must be actively promoted, it is conceivable that the operating temperature, the boiling point of the solvent etc. is already sufficient to achieve vaporisation/evaporation. In typical applications, it is sufficient to allow a short period of time to elapse between the forming of the wet perovskite film and processing the wet perovskite film by the gas flow. The time period can be between 0.1 second and 10 seconds. In Variants, the time period can be less than 0.1 second or more than 10 seconds, in particular between 10 seconds and 1 minute or even more than 1 minute.

Preferably, the carrier gas comprises air, in particular dry air, N₂, Argon or a mixture thereof. In Variants, other carrier gas known by the skilled in the art can be used.

Preferably, the processing agent is added to the carrier gas, in particular by injection or by bubbling, and wherein preferably the carrier gas and the processing agent are mixed in a mixing process, in particular to make a uniform gas solution. By adding the processing agent to the carrier gas, the processing agent can be applied to the wet perovskite film very efficiently. The mixing device achieves a homogeneous distribution of the processing agent in the carrier gas, resulting in a uniform distribution in the wet perovskite film and finally in the solar cell. In Variants, the processing agent can be applied independently of the carrier gas, for example as a mist, vapour or the like. Therewith, the processing agent can be applied in pure form or in a liquid solution or a suspension or the like.

Preferably, the processing agent comprises a reactive material, in particular a reactive gas, a reactive liquid, a reactive solid or a mixture thereof, more preferably a trace reactive material or a mixture thereof. Reactive material is a material that undergoes a chemical or electrochemical reaction with the wet perovskite film. The processing agent can further be a doping agent.

In Variants, the processing agent does not need to be a reactive material. Also inert material can be used as processing agent.

Preferably, the processing agent comprises a liquid, wherein the liquid is preferably evaporated in the carrier gas, a solid, wherein the solid is preferably sublimated in the carrier gas or a mixture thereof. The processing agent in the carrier gas particularly comprises an amount between 10⁻⁴ wt.Y and 25 wt.%, in particular beween 10⁻² wt.Y and 5 wt.% The amount can also be below 10⁻⁴ wt.% or above 25 wt.%. The exact amount of processing agent is optimized based on the solar cell performance.

Preferably, the processing agent comprises a reactive organic compound, metal halides, organometallic compounds or mixtures thereof, preferably an organic solvent, in particular one of, or a mixture comprising one or more of the following compounds:
i. a liquid alcohol, in particular an aliphatic alcohol, preferably an isoalcohol, more preferably isopropanol;
ii. a liquid nitrile compound, in particular further comprising an alkoxy group, preferably a methoxy group, in particular 3-Methoxypropionitrile;
iii. a liquid amino-compound, in particular an aliphatic amine, more preferably a primary aliphatic amine, in particular N-butylamine;
iv. a nitril, in particular acetonitrile;
v. a halogenated all<an, in particular a halogenated methane, preferably dichloromethane;
vi. an ammonium compound, in particular a primary, secondary or tertiary ammonium compound, more preferably methyl ammonium chloride;
vii. an amidin compound, in particular a salt of formamidinium, more preferably formamidinium chloride.

However, the skilled person knows other agents that can bring advantages in the production of the coating of perovskite solar cells.

Preferably, the process further provides for reliable control of the ink solvent evaporation and wet film formation. This is typically implemented by controlled flow of gas (usually dry air) with specified temperature over the inl<, while the ink is spreading on the surface.The flow of air over the ink is a known method of drying. In particular, for slot die coating of perovskite layer, an air knife technique is sometimes used for fast drying the wet film. The effectiveness of the air flow in increasing the evaporation rate of DMF is dependent on the flow speed, as well as the flow temperature. For air knife, a very high speed of air is usually used to completely dry out the film. However, in the context of the present invention, final wet film with controlled DMF content is preferably required for the optimum results. This requires optimized flow rate and flow temperature during the ink deposition.

The process involves applying a flow of a carrier gas (preferably dry air or N2), preferably at a certain flow rate and preferably at a controlled temperature, over the wet film at high viscosity regime. The carrier gas is preferably activated by a reactive gas by injection of a reactive material into the carrier gas. Preferably, addition of reactive material can be performed by injecting a liquid into the flowing carrier gas, by bubbling, or by direct injection of reactive gas into the carrier gas.

Preferably, a temperature and a flow speed rate of the carrier gas comprising the processing agent is controlled, wherein temperature is between 5 °C and 90 °C, more preferably between 10 °C and 80 °C. However, the temperature can be below 5 °C or above 90 °C. Preferably a flow speed rate of the carrier gas is in the range of 10 cm/s to 30'000 cm/s, in particular in the range of 100 to 1'000 cm/s. However, the flow speed rate can also be below 10 cm/s or above 30'000 cm/s.

Further, preferably additionally or alternatively to controlling the flow speed rate, a flow rate of the carrier gas comprising the processing agent is controlled, wherein a flow rate is preferably between 1 L/min and 70 L/min, more preferably between 1 L/min and 50 L/min, in particular between 5 L/min and 20 L/min, and, preferably, a temperature is between 5 °C and 90 °C, more preferably between 10 °C and 80 °C. However, controlling the flow rate can be also omitted, if the flow speed rate is controlled.

Even if it is preferable to control both the temperature and the flow speed, under certain circumstances it may be sufficient to control only the temperature or only the flow speed.

Preferably, a duration time during the wet perovskite film is processed by the flow of carrier gas is between 1 second and 60 second, in particular between 10 seconds and 40 seconds. Experiments have shown that this period of time is generally sufficient to achieve the desired adsorption in the wet perovskite film in order to achieve the desired effect. In variants, however, the time span can also be less than 1 second or more than 60 seconds.

Preferably, the process comprises one or more of the following steps:
i. Controlling the temperature of the carrier gas in a temperature control unit;
ii. Injecting one or more processing agents into the carrier gas, in particular by using one or more injection ports, in particular before or after controlling the temperature of the carrier gas in the temperature control unit;
iii. In particular, mixing the processing agent and the carrier gas in a mixing unit;
iv. Processing the wet perovskite film by the carrier gas comprising the processing agent, in particular at a predetermined and controlled flow speed rate.

More preferably, the process comprises all the above steps.

Preferably, the carrier gas supply device further comprises a temperature control unit for controlling the temperature of the carrier gas comprising an inlet for the carrier gas, an outlet for the carrier gas and a tempering unit in fluid communication with and between the inlet and the outlet for tempering the carrier gas. In variants, the temperature control unit can be omitted.

Preferably, the carrier gas supply device further comprises at least one mixing device downstream or upstream of the temperature control unit for mixing the processing agent with the carrier gas. In variants, the mixing device unit can be omitted.

Preferably, the at least one mixing device is located downstream of the at least one injection port, wherein preferably the at least one injection port is located between the temperature control unit and the at least one mixing device.

Preferably, the carrier gas supply device comprises an air knife device, in particular comprising a low gas speed air knife connected to the injection port for injection a processing agent and a high gas speed air knife. Preferably, the high gas speed air knife is used for processing the wet perovskite film with pure processing gas, i.e. without processing agent.

Experiments have shown that the high gas speed air knife is not suitable for applying processing agent on the wet perovskite film. Therefore, preferably a second air knife is used as explained above.

However, in some embodiments the high gas speed air knife could also comprise an injection port for injecting a processing agent. The carrier gas supply device can also comprise solely one air knife, for example a high gas speed air knife comprising an injection port or a low gas speed air knife comprising the injection port.

The air knife is used in blade or slot-die coating for drying of the wet film and formation of the intermediate phase (where the wet perovskite film is in high-viscosity regime).

Preferably, the coating set up comprises a spin coating device for spinning the substrate during coating or a slot die device or a blade device. However, also other coating methods can be used, in particular such as spray, drop casting, inkjet printing, and other coating methods known in the art.

Other advantageous embodiments and combinations of features come out from the detailed description below and the entirety of the claims.

### Brief description of the drawings

The drawings used to explain the embodiments show:
- Fig. 1: a schematic view of the stages of the perovskite film between application of the ink on the substrate to the crystallized perovskite;
- Fig. 2: a schematic view of the process of processing the wet perovskite film with carrier gas comprising a processing agent;
- Fig. 3: a FESEM image of device configuration that incorporates a film of organic-inorganic perovskite crystals, representation of an exemplary n-i-p perovskite device structure;
- Fig. 4: a statistical comparison of power conversion efficiency (PCE) and fill factor (FF) for perovskite solar cells based on different wet layers;
- Fig. 5: the optical transmittance of perovskite films prepared by dynamic reactive gas process with 10 LPM flux of dry air at different stages (low and high viscosity) compared to control perovskite layer (No Flow: 0 LPM) deposited on glass/SnO₂ substrate;
- Fig. 6: a FESEM image related to top surface of perovskite films prepared by dynamic reactive gas process with 10 LPM flux of dry air at different stages (low and high viscosity) compared to control perovskite layer (No Flow) deposited on glass/SnO₂ substrate;
- Fig. 7a-7c: an exposement of the sample surface to dry air flow in three geometries (G1, G2 and G3);
- Fig. 8a: The box charts related to photovoltaic parameters statistics (VOC) showing the differences between structures having perovskite films deposited based on different wet layer exposed under different geometry of gas flow compared to control perovskite layer (No Flow);
- Fig. 8b: The box charts related to photovoltaic parameters statistics (PCE) showing the differences between structures having perovskite films deposited based on different wet layer exposed under different geometry of gas flow compared to control perovskite layer (No Flow);
- Fig. 8c: The box charts related to photovoltaic parameters statistics (FF) showing the differences between structures having perovskite films deposited based on different wet layer exposed under different geometry of gas flow compared to control perovskite layer (No Flow);
- Fig. 9: current density-voltage curves related to solar cells based on perovskite film deposited with exposing the wet layer to different flux of gas flow compared to REF sample (No Flow);
- Fig. 10: statistical box charts of photovoltaic parameters showing the improvement of performance of solar cells based on perovskite film deposited with exposing the wet layer to different flux of gas flow compared to REF sample (No Flow);
- Fig. 11: the optical transmittance of perovskite films prepared by dynamic reactive gas process with the different flow rates compared to control perovskite layer (No Flow: 0 LPM) deposited on glass/SnO2 substrate. The presence of interreference in the UV-vis transmittance spectrum and in the wavelength range of 900 to 1'100 nm confirms the formation of a perfect layer with complete and uniform coverage;
- Fig. 12: the top surface FESEM images illustrating snow flake formation at a very high flux of dry air compared to REF sample (No Flow);
- Fig. 13: the current density-voltage curves related to solar cells based on perovskite film deposited with exposing the wet layer to flux of gas flow with different temperatures compared to REF sample (No Flow);
- Fig. 14: the statistical box charts of photovoltaic parameters showing the performance improvement of devices based on wet layer exposed to flux air flow with a temperature in the range of RT-90 °C compared to the REF sample (No Flow);
- Fig. 15: the statistical box charts of series resistance showing the reduction of series resistance of devices based on wet layer exposed to flux air flow with a temperature in the range of RT-90 °C compared to the REF sample (No Flow);
- Fig. 16: the statistical box charts of photovoltaic parameters showing the performance improvement of devices based on wet layer exposed to flux of IPA-dry air flow compared to the REF sample (No Flow);
- Fig. 17: a comparison between stabilized power output and PCE obtained from general J-V curve, for perovskites devices prepared by dynamic reactive gas process containing various IPA dosage;
- Fig. 18: a top view of FESEM image related to perovskite film growns on glass/ITO/SnO2 prepared by dynamic reactive gas process for IPA-carrying dry air and unadulterated (unmixed, absolute) dry air;
- Fig. 19: a comparison between the PL spectra, for perovskites films prepared by dynamic reactive gas process containing various IPA dosage;
- Fig. 20: a graph of current density, and efficiency statistics (obtained from general J-V curve) showing the differences between structures having perovskite films deposited based on a wet layer with and without 3-MPN additive;
- Fig. 21: a comparison of PL spectra of different perovskite layer illustrates the effect of 3-MPN containing gas flow with a temperature of 40 °C compared to REF sample (No Flow);
- Fig. 22: the crystallographic growth orientation by XRD pattern of perovskite deposited on In-doped SnO₂ (ITO)/charge transporting layer of SnO₂ substrate;
- Fig. 23: the camera photo of perovskites films prepared by dynamic reactive gas process for BuA-carrying dry air and REF sample (No Flow);
- Fig. 24: top surface SEM images of perovskites films prepared by dynamic reactive gas process for BuA-carrying dry air and "No Flow" sample;

In the figures, the same components are given the same reference symbols.

### Preferred embodiments

The process relates to a modification treatment during the perovskite film deposition. In particular, it refers to a reactive gas flow treatment on the wet film when it is in the high viscosity regime.

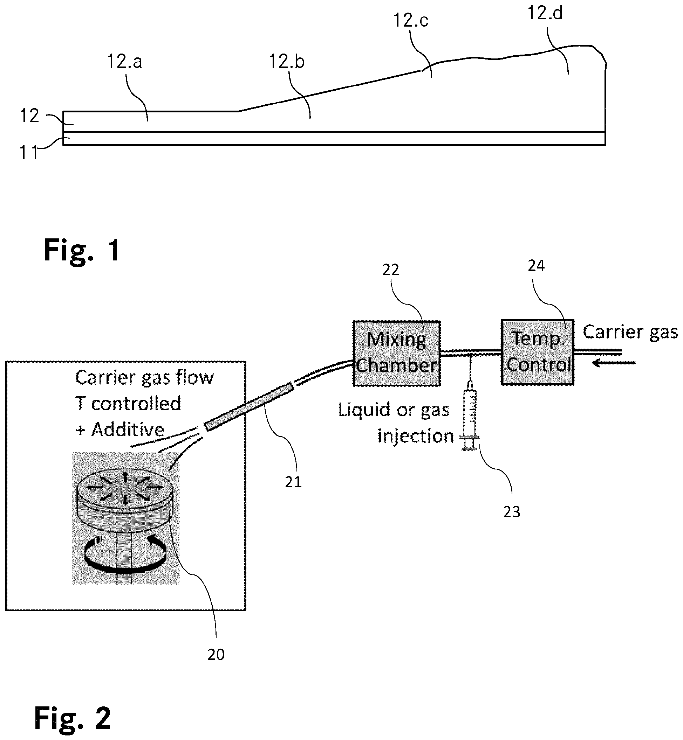

Figure 1 shows the most important stages that the perovskite film 12 goes through after application on the substrate 11.

The perovskite film deposition starts by applying a droplet of the perovskite solution (inl<) and spreading on the surface. In this stage, the perovskite is in the form of the initial solution 12.d. In spin coating, the droplet is spread by substrate rotation, while in blade coating or slot die coating the droplet is forced to spread by means of a moving blade. The initially constructed "wet film" 12.d contains high quantity of solvent and is in the low viscosity regime, as shown in the figure 1. A major part of the solvent is evaporated in seconds, the viscosity of the wet film increases from low 12.c to high 12.b. Finally, after evaporating all of the solvents, the solid, cristallized perovskite film 12.a is built. However, the modification process is preferably carried out in the high viscosity regime of wet film at 12.b.

The wet film should completely lose the solvent to form an intermediate phase. This intermediate phase is usually engineered to facilitate a more controlled nucleation and growth process. The intermediate phase is then converted to the final crystalline perovskite phase through thermal annealing.

Figure 2 shows a schematic view of the process of processing the wet perovskite film with carrier gas comprising a processing agent.

The flow rate of a carrier gas to the wet perovskite film 12, usually dry air or N₂, is regulated through a flow controller or valve 21. The temperature of the gas is also controlled by passing the carrier gas pipe through a hot/cold reservoir 24. A reactive liquid or gas, in a certain quantity is injected into the temperature-controlled carrier gas by injector 23. After, the carrier gas comprising the reactive liquid or gas is mixed in a mixing chamber 22. In case of liquids, the high speed of carrier gas and relatively small injection rate of liquid results in the liquid to be rapidly vaporized and added into the carrier gas. The chemically activated carrier gas is then blown onto the sample at the right time and interval.

The flow is usually set in the range 1-50 L/min, preferably 5-20 L/min. The flow rate is dependent on the size and geometry of the substrates and will normally be larger for larger area deposition. The flow detemines the rate that reactive gas touches the wet film. Hence, higher flow rate results in higher "doping" of the wet film. The flow rate also affects the rate of solvent evaporation in the wet film.

The temperature is ususally set in the range of 10 °C - 80 °C. Temperature has multiple effects; on how the injected liquid evaporates into the carrier gas, the evaporation rate of solvent in the wet film, and also the reaction of reactive gas with the wet film.

The reactive gas has a critical role in the process. There are various chemicals, that, if added to the wet film, result in a beneficial effect on the final perovskite film quality. Many of these chemicals cannot be added directly into the perovskite inl<, because they may degrade or de-stabilize the inl<. Therefore these chemicals are added in a controlled rate, into the wet film in the high viscosity regime by a carrier gas.

### Example 1 (REF).

In the first example, the manufacturing process of a reference solar cell (REF) based on the control perovskite layer is explained. In this example, no gas blowing is applied on the wet layer and there is no gas flow during deposition. Also, before starting the deposition process, the humidity of chamber is lowered with a dry air flow (50-70 LPM).

The planar n-i-p device is completed on indium-doped tin oxide (ITO)-coated glass or fluorine-doped tin oxide (FTO)-coated glass as the conductive transparent electrode and substrate. Next layer, SnO₂ as the electron transporting layer, is prepared by a SnCl₄-based molecular solution. The Perovskite layer on top of SnO₂ is the photoactive layer to absorb the sunlight. Then, the hole transporting layer (HTL) consisting of CuInS₂ semiconductor nanoparticles is applied onto the perovskite layer. Finally, a carbon/graphite composite electrode is deposited by blade coating onto HTL. The ETL and HTL are fabricated under fully open-air conditions.

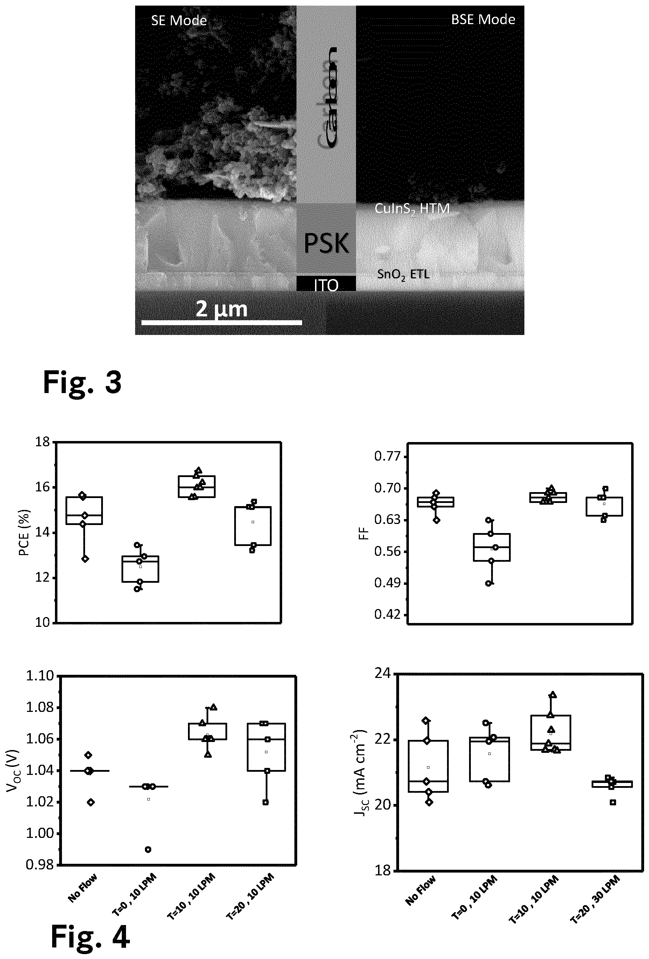

Figure 3 shows a FESEM image of device configuration that incorporates a film of organic-inorganic perovskite crystals, representation of an exemplary n-i-p perovskite device structure.

For n-i-p device fabrication, an ITO substrate was used as the front electrode and substrate. After patterning with laser scribing method (λ= 355 nm), washing process through a first brushing step in detergent and then successive processes of sonication in DI water, isopropanol, DI water, ethanol, DI water was done and finally drying was done in an oven at a temperature above 150 °C. The precursor solution was prepared by 5 times dilution of Alfa-SnO₂ colloidal dispersion (15 %wt in H₂O) in DI water. The fresh solution was spin coated at 4'000 rpm with a 1 second ramp for 30 seconds. Before injecting the solution, the UV-OZONE curing was done for 15 minutes. After finishing the coating, the substrates were immediately annealed at 150 °C for half an hour. The perovskite layer is sandwiched between the ETL and HTL layers.

Perovskite precursor solution was made by mixing following materials in 1 ml mixture solvent of DMF: DMSO (3.55:1); 548.60 mg of PbI₂, 57.06 mg of PbBr₂, 178.94 mg of FAI, 27.02 mg of Csl, 17.41 mg of MABr and 5.0 mg MACI to form composition of Cs0.08(MA0.12FA0.80)Pb(I2.64 Br0.36) + 0.034 excess PbI₂. To deposit perovskite layer, in the first stage, the humidity of the deposition chamber is reduced to 3 - 7% using dry air flow for 90 seconds at a rate of 70 liters per minute (LPM). The amount of 45 µl perovskite ink is injected on the substrate. In the third step, immediately after the completion of the 30 seconds spinning step, the layer is transferred to the vacuum system for 45 seconds, with a pressure of 10 Pa to form the intermediate phase. In this context, a vacuum flushing-based process has been considered to solvent removal and create supersaturation. In the fourth step, the layer is annealed on a hot plate with a temperature of 120 °C for 45 minutes.

The CIS deposition as HTL was done with two times deposition of nanoparticle ink by spin coating method; 30 seconds of rotation at a speed of 2'000 rpm with a 1 second ramp.

After finishing each layer, the substrates were annealed at 100 °C for 6 minutes. The carbon/graphite electrode was used as the back electrode by Dr. Blade's method and dried in the oven for half an hour at 100 °C.

### Example 2.

The solar cell devices in example 2 were fabricated with the above-described procedure of example 1 except for exposing the sample surface to dry air flow during the deposition of perovskite layer. In this way, the reference sample is a sample that has not experienced any gas flow. For other perovskite layers, dry air blowing at different time steps were investigated during the wet layer formation. The spin coating method for deposition of perovskite layer is applied in two stages: (10 seconds-1'000 RPM and 30 seconds-6'000 RPM). Air blowing with a flow rate of 10 LPM was applied at time steps of T=0, 10 and 20 seconds after start of spinning. The best performance was obtained for perovskite solar cells made based on deposited perovskite under dry air blowing at the beginning of 6'000 rpm (Champion cell = 16.74% and on average =16.63%). On the other hand, the worst results were obtained for perovskite solar cells using the deposited perovskite under dry air blowing at the start of 1'000 rpm stage and at a rate (champion cell = 13.45% and on average = 12. 67%).

Figure 4 shows the comparison of power conversion efficiency (PCE) and fill factor (FF) for perovskite solar cells based on different wet layers exposed with 10 LPM flux of dry air at different stages.

The results show useful properties of gas flowing. The injection time of applied dry air flux is an effective parameter on the evaporation rate of the solvent and the wet layer formation. More specifically, the results show an increase in all photovoltaic parameters of open circuit voltage, a short circuit current density, fill factor, and power conversion efficiency for optimum injection time of gas flowing (10 seconds, high viscosity regime). A high viscosity regime is preferred.

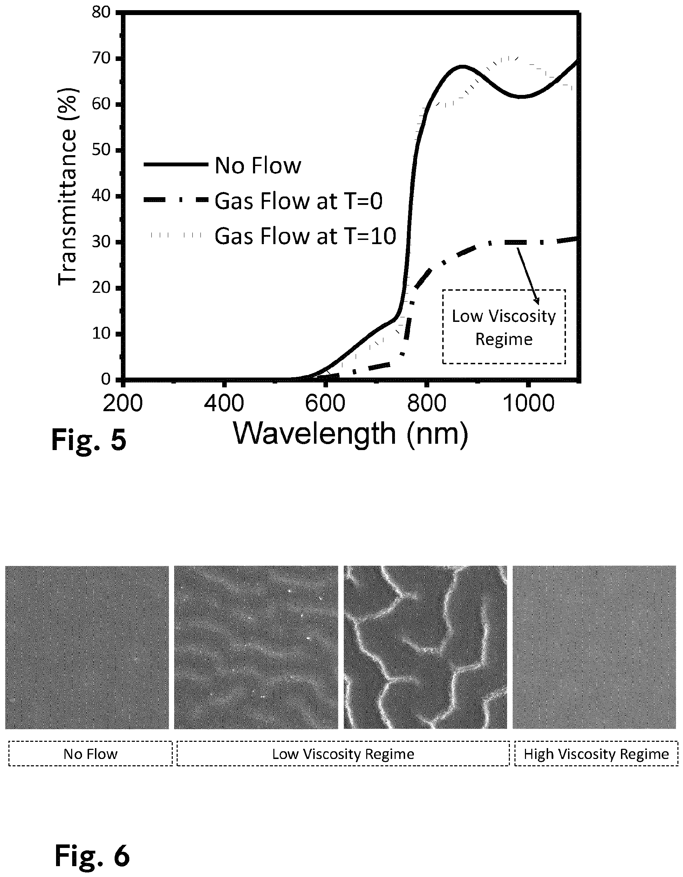

Gas flow at injection time of high viscosity regime resulted in a mirror like surface as could be seen from the Figure 5. The constructive and destructive optical interferences between light reflected from the surface of the perovskite film and the ITO substrate result in an interference pattern in longer wavelength When the wet layer was exposed to dry air from the first step of spin coating or in a low-viscosity regime (too wet), a rough appearance with a wrinkled surface is formed (Figure 6).

Figure 5 shows the optical transmittance of perovskite films prepared by dynamic reactive gas process with 10 LPM flux of dry air at different stages (low and high viscosity) compared to control perovskite layer (No Flow: 0 LPM) deposited on glass/SnO₂ substrate.

Figure 6 shows the FESEM images related to top surface of perovskite films prepared by dynamic reactive gas process with 10 LPM flux of dry air at different stages (low and high viscosity) compared to control perovskite layer (No Flow) deposited on glass/SnO₂ substrate.

### Example 3.

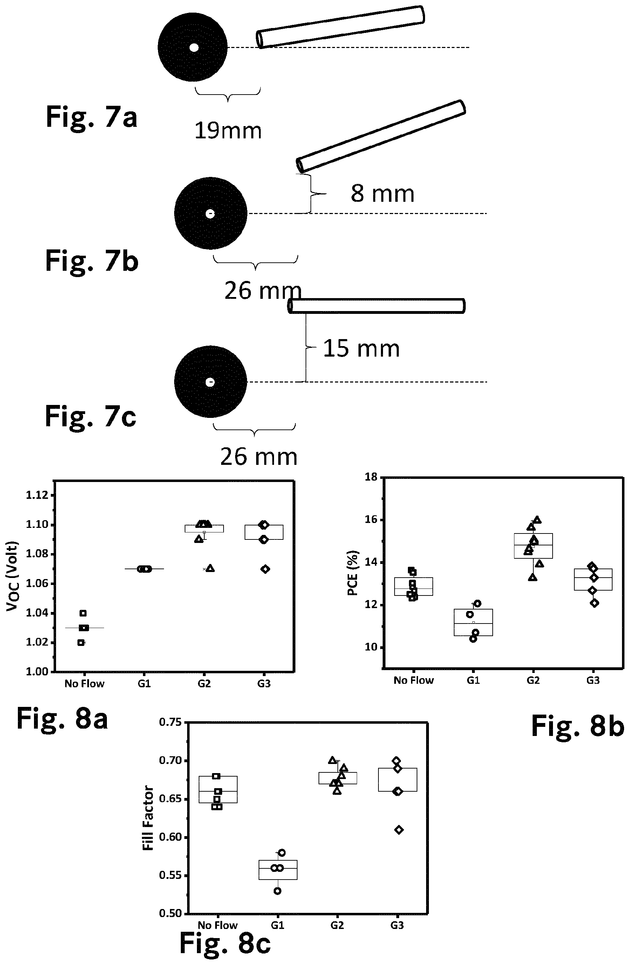

The solar cell devices in example 3 were fabricated with the above-described procedure of example 1 except for exposing the sample surface to dry air flow in three geometries (G1, G2 and G3) as illustrated in Figure 7. A series of solar cell devices were prepared. To deposit perovskite layer, the dry air was firstly blown from the bottom of the chamber with a flow of 50 LPM into the dry box chamber to reduce humidity to 9%. A 40 µl of perovskite ink was dropped on the substrate. The spin coating process was done in two steps: 10 seconds 1'000 rpm; 30 seconds 6'000 rpm. The air blowing with a flow rate of 10 LPM was applied on 10 seconds after spin starting in which the temperature of dry air was 45 °C. In this way, the reference sample is a sample that has not experienced any gas flow on the surface.

Figure 7 shows the different geometries of gas flow applied on the wet layer during the perovskite layer deposition.

In terms of maximum efficiency, the average efficiency of 11.19%, 14.75% and 12.68% was obtained for G1, G2 and G3 groups, respectively. The results show that the geometry of air flow is completely effective on the performance of the photovoltaic device. The highest current density, fill factor and VOC is obtained for G2. With parallel and direct blowing of air on wet film (G1) a drop in photovoltaic parameters is observed. Figure 8 illustrates statistical box charts of PCEs of perovskite-based solar cells, according to parameters of the present example.

Figure 8a shows box charts related to photovoltaic parameters statistics (VOC) showing the differences between structures having perovskite films deposited based on different wet layer exposed under different geometry of gas flow compared to control perovskite layer (No Flow).

Figure 8b shows box charts related to photovoltaic parameters statistics (PCE) showing the differences between structures having perovskite films deposited based on different wet layer exposed under different geometry of gas flow compared to control perovskite layer (No Flow).

Figure 8c shows box charts related to photovoltaic parameters statistics (FF) showing the differences between structures having perovskite films deposited based on different wet layer exposed under different geometry of gas flow compared to control perovskite layer (No Flow).

### Example 4

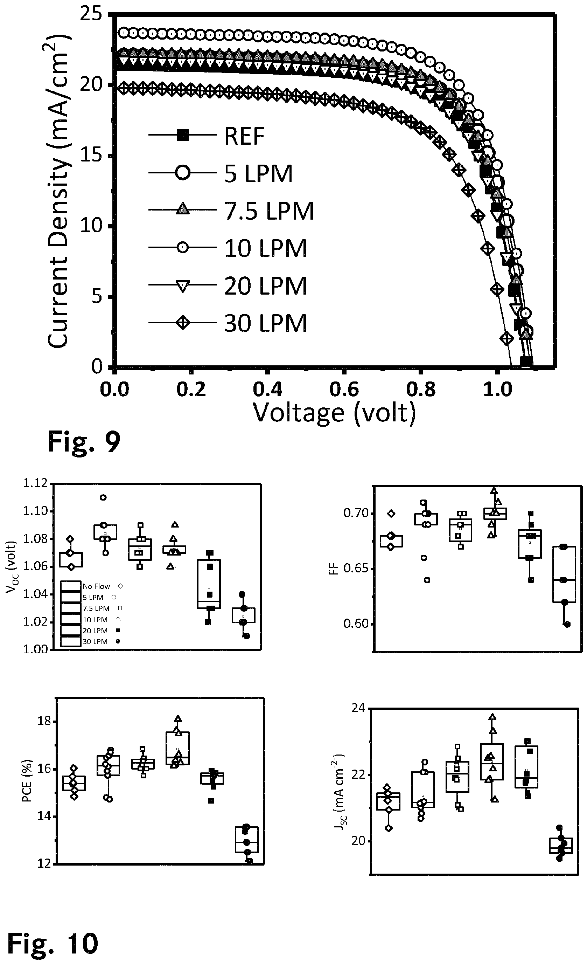

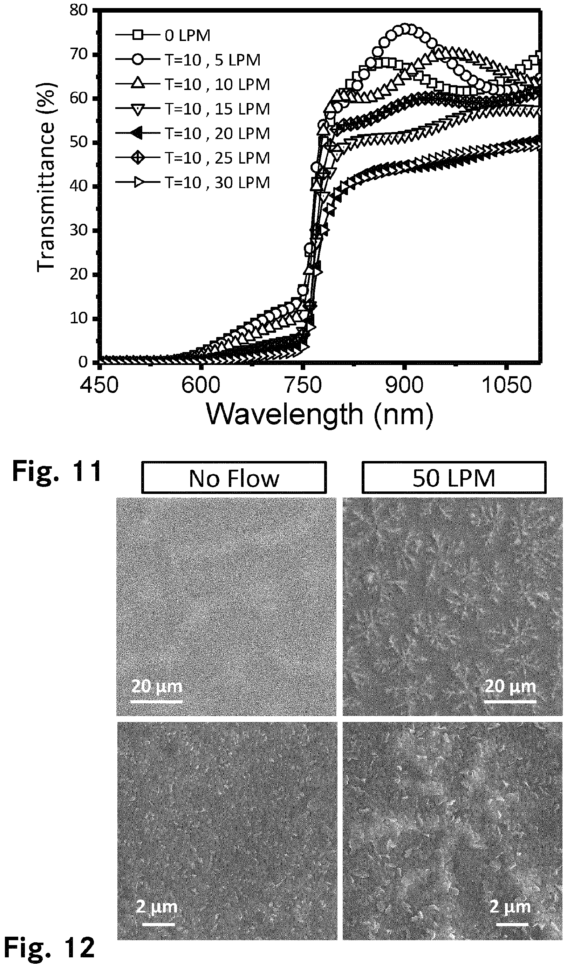

The solar cell devices in example 4 were fabricated with the above-described procedure of example 1 except for exposing the sample surface to dry air flow with a rate of 5, 7.5, 10, 20 and 30 LPM at T=10 seconds after start of spinning (high viscosity regime) during the wet layer formation. The temperature of dry air was set at 40 °C. The blowing path is adjusted with the appropriate geometry of G2. The reference sample is a sample that has not experienced any gas flow. As could be seen from Figures 9 and 10, the results show good photovoltaic performance for perovskite films deposited with the gas flow with a rate of 5 to 10 LPM. More specifically, the results show an open circuit voltage of 1.09 V, a short circuit current density of 23.73 mA/cm², fill factor of 0.7, and a conversion efficiency of 18.1% for the condition of blowing with a 10 LPM gas flow. On the other hand, a high rate for the gas blowing resulted in a rough surface which is obvious for transmittance spectra in Figure 11. The formation of snowflal<es in very high gas flux is also shown in Figure 12, which confirms the effectiveness of air flow on the surface of the wet layer.

Figure 9 shows the current density-voltage curves related to solar cells based on perovskite film deposited with exposing the wet layer to different flux of gas flow compared to REF sample (No Flow).

Figure 10 shows the statistical box charts of photovoltaic parameters showing the improvement of performance of solar cells based on perovskite film deposited with exposing the wet layer to different flux of gas flow compared to REF sample (No Flow).

Figure 11 shows the optical transmittance of perovskite films prepared by dynamic reactive gas process with the different flow rates compared to control perovskite layer (No Flow: 0 LPM) deposited on glass/SnO2 substrate. The presence of interference in the UV-vis transmittance spectrum and in the wavelength range of 900 to 1'100 nm, confirms the formation of a perfect layer with complete and uniform coverage.

Figure 12 shows the top surface FESEM images illustrating snow flake formation at a very high flux of dry air compared to REF sample (No Flow).

### Example 5

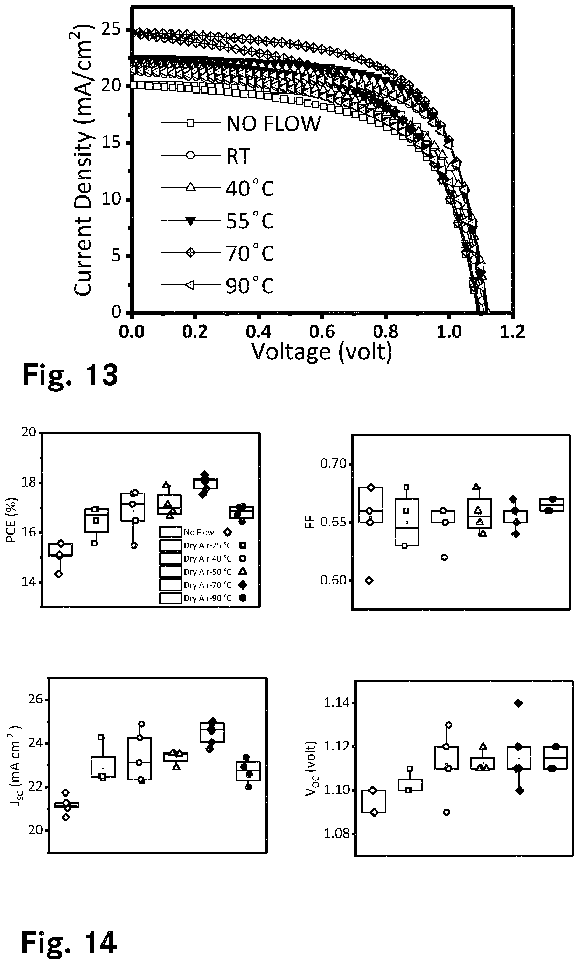

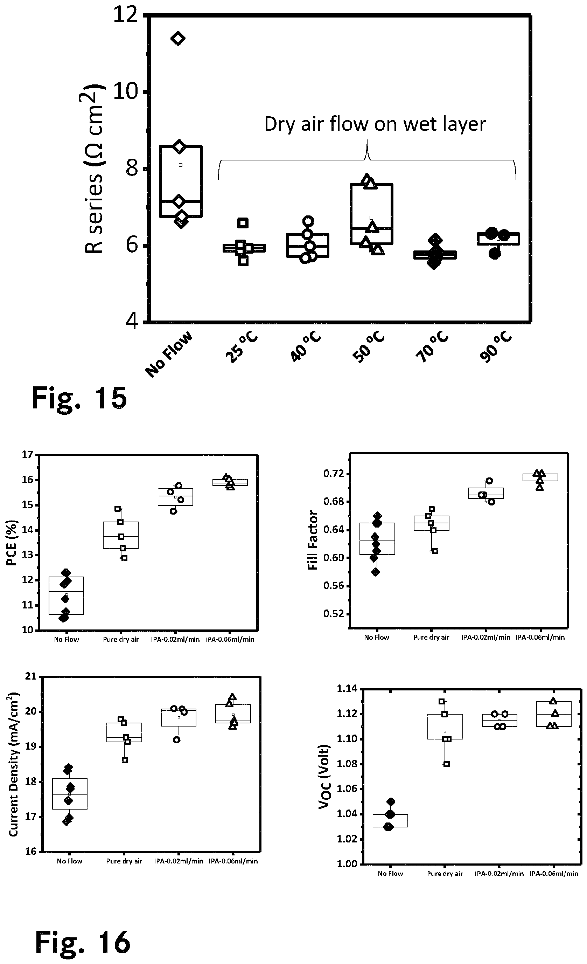

The solar cell devices in example 4 were fabricated with the above-described procedure of example 1 except for exposing the sample surface to dry air flow with a rate of 10 LPM at T=10 seconds after start of spinning (high viscosity regime) during the wet layer formation. The temperature of dry air was set at the following values: 25, 40, 50, 70 and 90 °C. The blowing path is adjusted with the appropriate geometry of G2. The reference sample is a sample that has not experienced any gas flow. As could be seen from Figures 13 and 14, The results show good photovoltaic performance for perovskite films deposited with the gas flow. More specifically, the results show an open circuit voltage of 1.12 V, a short circuit current density of 24.68 mA/cm2, fill factor of 0.66, and a conversion efficiency of 18.32% for the condition of blowing with a 70 °C gas flow. On the other hand, REF sample shows a higher series resistance as could be seen from the Figure 15.

Figure 13 shows the current density-voltage curves related to solar cells based on perovskite film deposited with exposing the wet layer to flux of gas flow with different temperatures compared to REF sample (No Flow).

Figure 14 shows the statistical box charts of photovoltaic parameters showing the performance improvement of devices based on wet layer exposed to flux air flow with a temperature in the range of RT-90 °C compared to the REF sample (No Flow).

Figure 15 shows the statistical box charts of series resistance showing the reduction of series resistance of devices based on wet layer exposed to flux air flow with a temperature in the range of RT-90 °C compared to the REF sample (No Flow).

### Example 6.

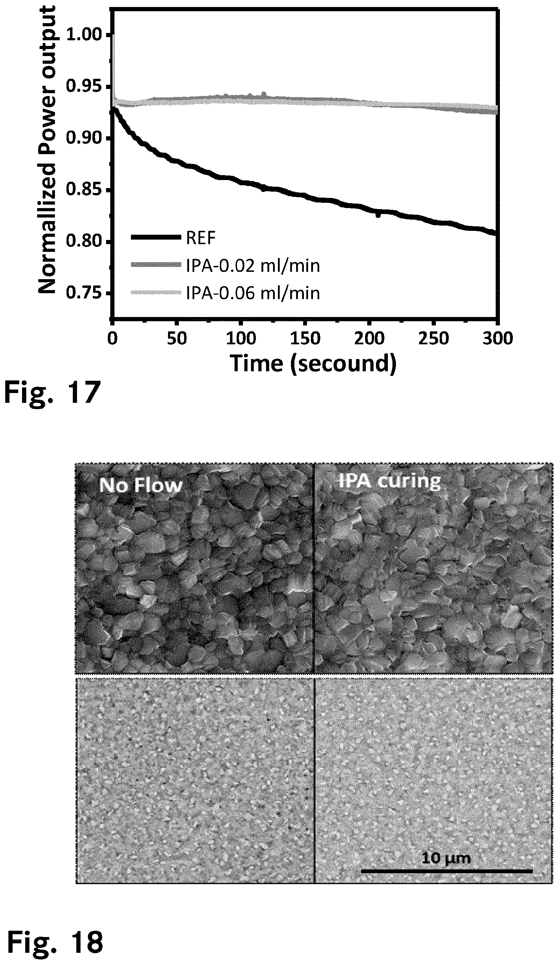

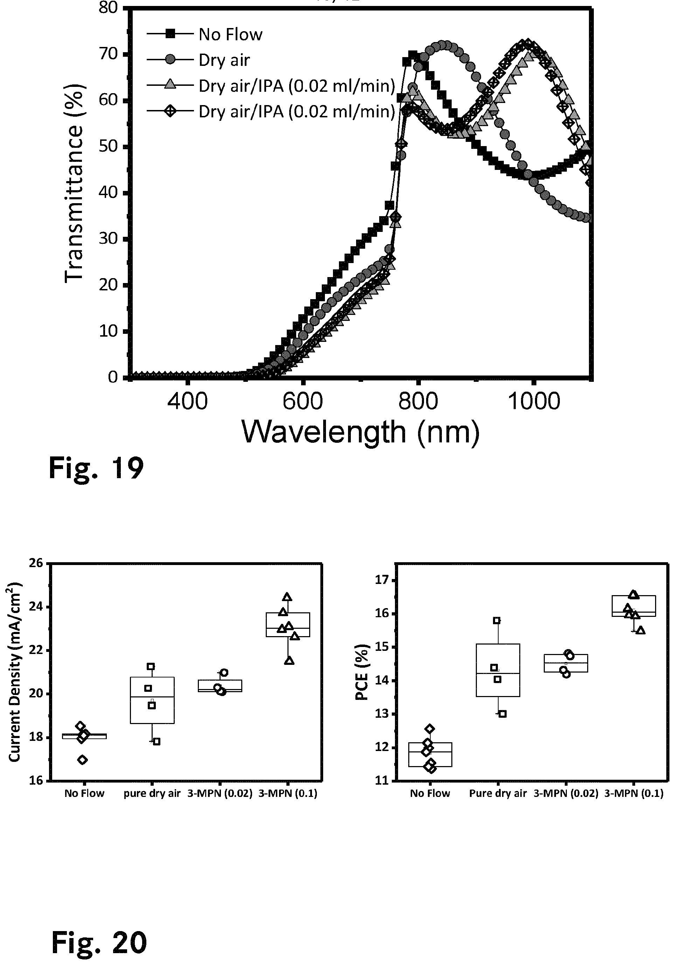

The above-described evaluation of example 1 was repeated for the solar cell element of example 6, except for that a mixed dry air flow with isopropanol (IPA, C₃H₈O) with different doses was used. The air flow temperature was set at 40 °C. To deposit perovskite layer, in the first stage, the humidity of the deposition chamber is reduced to 3-7% using dry air flow for 90 seconds at a rate of 70 LPM. The amount of 45 µl perovskite ink is injected on the substrate. At the end of the 1'000 rpm stage (10 seconds) and the beginning of the 6'000-rpm stage (30 seconds), the mixture gas flow vapor is blown at the set speed (10 LPM). The blowing path is adjusted with the appropriate geometry. In the third step, immediately after the completion of the 30 seconds spinning step, the layer is transferred to the vacuum system for 45 seconds, with a pressure of 10 Mpa, to form the intermediate phase. In vacuum curing, the wet film produced by spreading the perovskite ink is placed in a vacuum chamber, and the pressure is reduced to 0.1-100 Pa, so that the solvent of the ink (usually DMF) is completely evaporated and an intermediate phase of perovskite-DMSO is formed. The reference sample is a sample that has not experienced any gas flow. The "pure dry air" samples were made in the same structure as the treated samples with the difference that the gas flow contained only dry air. The impact of using IPA carrying warm gas in the wet film formation was investigated by characterizing the solar cell device performance in comparison with control samples. Several sets of photovoltaic cells were fabricated as shown statistically illustrated in Figure 16. The use of IPA for perovskite film treatment was associated with successful results, which leads to all photovoltaic parameter improvement compared to the control solar cells. The formation of a layer with mirror-like top surface by exposing of wet layer with gas flow contain IPA additive during the deposition process is confirmed. Based on the Figure 17, a more stable perovskite solar cell is obtained with IPA treatment of wet layer. Based on Figure 18, the IPA treated perovskite layer shows a pinhole free surface, however, the control perovskite layer shows pin holes on the surface. The approach introduced in this context is an effective strategy for wet layer treatment to control the solvent evaporation mode and intermediate phase formation. Generally, mirror-like surface with low roughness, pinhole and crack-free layer, homogeneous surface coverage, no formation of cafe ring and snowflakes, and suitable thickness are important apparent properties which strongly depend on the properties of the wet layer. The optical transmittance of perovskite films prepared by dynamic reactive gas containing IPA, compared to control perovskite layer (No Flow) is shown in Figure 19. The presence of interreference in the UV-vis transmittance spectrum and in the wavelength range of 900 to 1'100 nm confirms the formation of a perfect layer with complete and uniform coverage. The IPA treated samples show a higher absorbance around 500 to 800 nm.

Figure 16 shows the statistical box charts of photovoltaic parameters showing the performance improvement of devices based on wet layer exposed to flux of IPA-dry air flow compared to the REF sample (No Flow).

Figure 17 shows a comparison between stabilized power output and PCE obtained from general J-V curve, for perovskites devices prepared by dynamic reactive gas process containing various IPA dosage.

Figure 18 shows a top view of FESEM image related to perovskite film growns on glass/ITO/SnO2 prepared by dynamic reactive gas process for IPA-carrying dry air and unadulterated (unmixed, absolute) dry air.

Figure 19 shows a comparison between the PL spectra, for perovskites films prepared by dynamic reactive gas process containing various IPA dosage.

### Example 7.

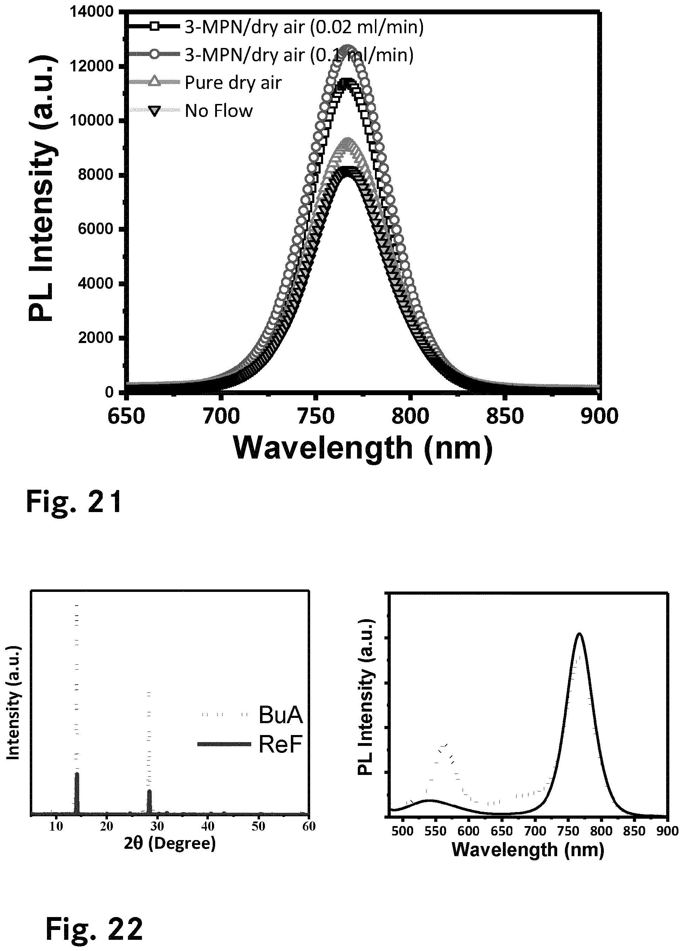

A solar cell element of example 7 was obtained with the above-described procedure of example 1 except for that at the end of the 1'000 rpm stage (10 seconds) and the beginning of the 6'000 rpm stage (30 seconds), the mixture of dry air flow and 3-Methoxypropionitrile (3-MPN, C₄H₇NO) vapor is blown at the set speed (10 LPM). The reference sample is a sample that has not experienced any gas flow. The "pure dry air" samples were made in the same structure as the treated samples with the difference that the gas flow contained only dry air. The use of 3-MPN for perovskite film treatment was associated with successful results, which leads to a 4% efficiency improvement compared to the "No Flow" solar cells and increases the efficiency compared to "pure dry air" from 13.50% to 16.06% on average (Figure 20). The 3-MPN doped perovskite layers show a higher photoluminescent intensity (Figure 21)

Figure 20 shows a graph of current density, and efficiency statistics (obtained from general J-V curve) showing the differences between structures having perovskite films deposited based on a wet layer with and without 3-MPN additive.

Figure 21 shows a comparison of PL spectra of different perovskite layer, illustrates the effect of 3-MPN containing gas flow with a temperature of 40 °C compared to REF sample (No Flow).

### Example 8.

The above-described evaluation of example 1 was repeated for the solar cell element of example 8 except for that a mixed dry air flow with N-butylamine (CH₃(CH₂)₃NH₂, BA) at temperature 40 °C was used. N-butylamine contained dry air is blown at the set speed (10 LPM) and the injection rate of N-butylamine is set on 0.04L/min. The impact of wet film formation, was investigated by characterizing the XRD, PL, FESEM in comparison with control samples (No Flow). Based on the Figures 22, 23 and 24 the formation of 3D/2D perovskite layer with mirror-like top surface and snowflake-free rear surface and low amount of PbI₂ secondary phases were achieved by exposing of wet layer with very small amounts of a BA additive during the deposition process.

Figure 22 shows the crystallographic growth orientation by XRD pattern of perovskite deposited on In-doped SnO₂ (ITO)/charge transporting layer of SnO₂ substrate. For comparison, the control perovskite film (REF) is also prepared without any gas flow. The diffraction peak around 12.60 related the secondary phase of PbI₂ is very weak in comparison with REF sample. This film has a strong (100) X-ray diffraction peak, confirms a face-up orientation. The right picture is related to PL spectra. A high crystalline perovskite layer was obtained for BuA treated layers. The shoulder peaks in PL spectra illustrate the 2D/3D perovskite formation. The top surface SEM images in Figure 19 confirms the significant growth of the perovskite layer based on the BuA modified wet layer. Grain boundaries have largely disappeared.

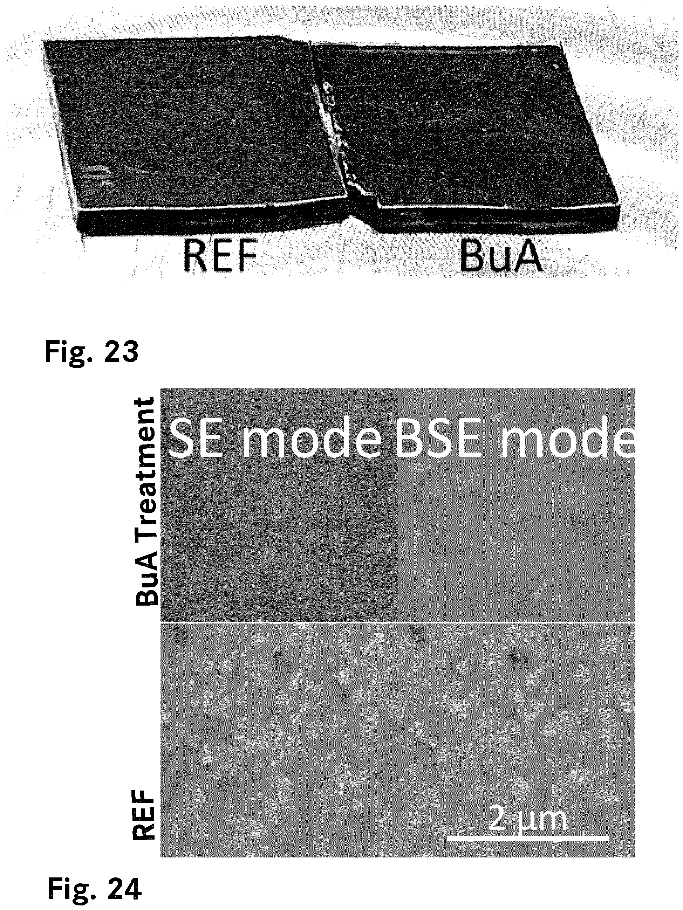

Figure 23 shows the camera photo of perovskites films prepared by dynamic reactive gas process for BuA-carrying dry air and REF sample (No Flow).

Figure 24 shows top surface SEM images of perovskites films prepared by dynamic reactive gas process for BuA-carrying dry air and "No Flow" sample.

### Summary

The present invention generally relates to a dynamic system that with a combination of gas blowing, gas temperature and gas chemistry elements results in a scalable useful reactive atmosphere, in which a sufficiently wet layer of perovskite precursor solution is exposed to a reactive gas flow. In this context, a process to form a perovskite layer, as the light absorbing layer in a solar cell consisting of the following steps: (i) Spreading the perovskite ink on the substrate to form a wet film, (ii) Applying a flow of dry air with a controlled temperature during the wet film formation, when the wet film is in suitable viscosity regime, (iii) Vacuum drying of the wet film to form the intermediate phase, (iv) Annealing the layer to form the perovskite phase. From the above-described results of examples 1 to 4, it can be understood that the perovskite solar cell according to an embodiment of the present invention obtains good properties by employing the gas flow. From the above-described results of example 4, it can be understood that a high viscosity regime is recommended for treatment of wet layer formation during spin coating. From the above-described results of example 5, it can be understood that more efficient solar cell having good photovoltaic properties can also be obtained by changing the temperature of gas flow more than RT and lower than 90 °C. From the above-described results of examples 6 and 7, a solar cell having good properties can also be obtained by employing not only 40 °C gas flow but mixing with suitable organic compound for the doping.

## Claims

1. Process for the formation of a perovskite film on a substrate, in particular for the manufacture of a perovskite solar cell, wherein a solution comprising perovskite-precursors and a solvent is deposited on the substrate with which a wet perovskite film is formed on the substrate, **characterized in that** the wet perovskite film is processed by a flow of a carrier gas and a processing agent, wherewith the wet perovskite film is processed by the processing agent.

2. Process according to claim 1, **characterized by** at least one of the following features
i) during the processing with the processing agent, the wet perovskite film is in a high viscosity regime;
ii) a flow speed of the flow of the carrier gas is controlled in order to regulate the solvent evaporation from the wet perovskite film, wherein, in particular, the flow of the carrier gas starts, when the wet perovskite film is in high viscosity regime, in particular between 0.1 second and 10 seconds after the wet perovskite film is formed on the substrate;
iii) a temperature of the carrier gas is controlled;
iv) the processing agent, in particular a reactive agent, preferably with a certain dose, is injected into the carrier gas in order to deposit the reactive agent into the wet film.

3. Process according to claim 1 or 2, **characterized in that** the processing agent is adsorbed at least partially in the wet perovskite film.

4. Process according to one of claims 1 to 3, **characterized in that** between forming the wet perovskite film and processing the wet perovskite film by the gas flow, a viscosity of the wet perovskite film is increased, in particular by evaporating the solvent at least partially, in particular by heating, by vaporizing under negative pressure or a combination thereof.

5. Process according to one of claims 1 to 4, **characterized in that** the carrier gas comprises air, in particular dry air, N₂, Argon or a mixture thereof.

6. Process according to one of claims 1 to 5, **characterized in that** the processing agent is added to the carrier gas, in particular by injection or by bubbling, and wherein the carrier gas and the processing agent are mixed in a mixing process, in particular to make a uniform gas solution.

7. Process according to one of claims 1 to 6, **characterized in that** the processing agent comprises a reactive material, in particular a reactive gas, a reactive liquid, a reactive solid or a mixture thereof, more preferably a trace reactive material or a mixture thereof.

8. Process according to one of claims 1 to 7, **characterized in that** the processing agent comprises a liquid, wherein the liquid is evaporated in the carrier gas, a solid, wherein the solid is sublimated in the carrier gas or a mixture thereof, wherein the processing agent in the carrier gas particularly comprises an amount between 10⁻⁴ wt.Y and 25 wt.%.

9. Process according to claim 8, **characterized in that** the processing agent comprises a reactive organic compound, metal halides, organometallic compounds or mixtures thereof, preferably an organic solvent, in particular one of, or a mixture comprising one or more of the following compounds:
i. a liquid alcohol, in particular an aliphatic alcohol, preferably an isoalcohol, more preferably isopropanol;
ii. a liquid nitrile compound, in particular further comprising an alkoxy group, preferably a methoxy group, in particular 3-Methoxypropionitrile;
iii. a liquid amino-compound, in particular an aliphatic amine, more preferably a primary aliphatic amine, in particular N-butylamine;
iv. a nitril, in particular acetonitrile;
v. a halogenated all<an, in particular a halogenated methane, preferably dichloromethane;
vi. an ammonium compound, in particular a primary, secondary or tertiary ammonium compound, more preferably methyl ammonium chloride;
vii. an amidin compound, in particular a salt of formamidinium, more preferably formamidinium chloride.

10. Process according to one of claims 1 to 9, **characterized in that** a temperature and a flow speed rate of the carrier gas comprising the processing agent is controlled, wherein temperature is between 5 °C and 90 °C, more preferably between 10 °C and 80 °C and, preferably a flow speed rate of the carrier gas is in the range of 10 to 30'000 cm/s, in particular in the range of 100 to 1'000 cm/s.

11. Process according to one of claims 1 to 9, **characterized in that** a duration time during the wet perovskite film is processed by the flow of carrier gas is between 1 second and 60 seconds, in particular between 10 seconds and 40 seconds.

12. Process according to one of claims 1 to 11, **characterized by** the steps of
v. Controlling the temperature of the carrier gas in a temperature control unit;
vi. Injecting one or more processing agents into the carrier gas, in particular by using one or more injection ports, in particular before or after controlling the temperature of the carrier gas in the temperature control unit;
vii. In particular, mixing the processing agent and the carrier gas in a mixing unit;
viii. Processing the wet perovskite film by the carrier gas comprising the processing agent, in particular at a predetermined and controlled flow speed rate.

13. Device for the formation of a perovskite film on a substrate, comprising a coating set up for coating a substrate with a solution comprising perovskite-precursors and a solvent, wherewith a wet perovskite film can be deposited on the substrate, and a carrier gas supply device with which a gas flow can be directed to coating set up, in particular to the substrate comprising the wet perovskite film, **characterized in that** the carrier gas supply device further comprises at least one injection port for injecting a processing agent into the carrier gas, wherewith the wet perovskite film can be processed by the processing agent.

14. Device according to claim 13, **characterized in that** the carrier gas supply device further comprises a temperature control unit for controlling the temperature of the carrier gas comprising an inlet for the carrier gas, an outlet for the carrier gas and a tempering unit in fluid communication with and between the inlet and the outlet for tempering the carrier gas.

15. Device according to claim 13 or 14, **characterized in that** the carrier gas supply device further comprises at least one mixing device downstream or upstream of the temperature control unit for mixing the processing agent with the carrier gas.

16. Device according to claims 13 and 15, **characterized in that** the at least one mixing device is located downstream of the at least one injection port, wherein preferably the at least one injection port is located between the temperature control unit and the at least one mixing device.

17. Device according to one of claims 13 to 16, **characterized in that** the carrier gas supply device comprises an air knife device, in particular comprising a low gas speed air knife connected to the injection port for injecting a processing agent and a high gas speed air knife.

18. Device according to one of claims 13 to 17, **characterized in that** the coating set up comprises a spin coating device for spinning the substrate during coating or a slot die device or a blade device.
